# EUROPEAN PATENT APPLICATION

(11) **EP 3 848 731 A1**
(43) Date of publication of application: **14.07.2021**
(21) Application number: 20217739.0
(22) Date of filing: 30.12.2020
(51) Int. Cl.: G01T 1/24

(54) **MODULAR GAMMA CAMERA AND MODULAR GAMMA CAMERA ASSEMBLY**

(30) Priority: 13.01.2020 CZ 20203712
(71) Applicant: Advacam s.r.o., 170 00 Praha 7 (CZ)
(72) Inventor: DOUBRAVOVA, Daniela, 13000 Praha 3 (CZ); JAKÜBEK, Jan, 26706 Hýskov (CZ)
(74) Representative: Sedlák, Jirí

(57) **Abstract**

The modular gamma camera (1) comprises at least one hybrid semiconductor detector (2) of transient ionizing radiation and at least one collimator (3) of transient ionizing radiation arranged in front of hybrid semiconductor detector (2) in the direction of propagation of transient ionizing radiation. The core of invention is based on the fact that the modular gamma camera consists of a housing (4) which has at least one opening (5) on the front side provided with a holder of an exchangeable collimator (3), and which has a rear side provided with means for connecting a heat sink (6), and its sides provided with connecting means for modular chain connection of adjacent housings (4). In housing (4) is placed at least one hybrid semiconductor detector (2) of transient radiation. The subject of the invention is modular gamma camera assembly (1) also, in which the housings (4) in the assembly are connected in a circle.

## Description

### Field of the Invention

The invention relates to the field of imaging techniques with the help of detection and digital recording of transient ionizing radiation.

### Background of the Invention

Imaging techniques that use transient ionizing radiation are increasingly used in many fields of human activity. They are used for quality control and non-destructive testing in industry, for diagnostics and therapy in medicine, science; they are also used for example in the control of luggage and consignments in security applications, etc. Imaging techniques utilize the penetrability of the type of transient ionizing radiation used through optically opaque objects to display their internal structure, or to obtain information about materials located within the structure.

Imaging detectors implementing these imaging techniques must always include an image sensor, on the detection surface area of which transient ionizing radiation is incident. The image sensor must therefore in particular have the ability to capture transient ionizing radiation. Because the transient ionizing radiation used has the ability to penetrate matter, it can also penetrate the imaging detector. The material and design of the sensor must therefore be specially adapted so that the detection efficiency is maximized for a given type of transient ionizing radiation, i.e. so that as many particles as possible of a given transient ionizing radiation, e.g. X-ray photons, generate a signal in the sensor.

In recent years, semiconductor detectors operating on the principle of a single conversion have been increasingly used for imaging as sensors of transient ionizing radiation, where incident ionizing radiation generates an electrical signal directly in the semiconductor element. A large number of elements working in this way are formed on one semiconductor chip, in professional circles called pixels, thus creating an image sensor, the so-called scan chip. The signal from each element, pixel, is further processed in specialized hardware and software, which creates the final image. These semiconductor radiation detectors are referred to as semiconductor pixel detectors or sensors. The hardware for processing electrical signals from individual pixels is often formed on an independent chip, called a read electronic chip, or shortly a read chip. The scan chip of a semiconductor pixel detector is usually located directly on the read chip, overlaps it, and is electrically connected to it by a matrix of contacts. Such an arrangement of both chips forms a permanent (non-removable) unit, which is referred to as a hybrid semiconductor pixel detector, or shortly a hybrid detector. In some cases, the read electronic chip is designed to digitally record information about each individual particle of transient ionizing radiation that has generated an electrical signal in the scan chip.

Examples of hybrid semiconductor detectors are the Medipix2, Medipix3, Timepix and Timepix3 semiconductor detectors known in the professional circles, or the Pilatus and Eiger detectors. The individual pixels of hybrid semiconductor detectors are usually square in shape with a side length of 55 µm for Medipix2, Medipix3, Timepix, Timepix3 chips, with a side length of 75 µm for Eiger chips, with a side length of 172 µm for Pilatus chips, etc. Therefore, the pixel size cannot be generalized to all hybrid semiconductor detectors.

Hybrid semiconductor detectors are already commonly used in cameras, as is known, for example, from document CZ 28 374 U, where scan chips are built side by side to create an arbitrarily large continuous detection surface area of the camera.

If a collimator of transient ionizing radiation is arranged next to the camera, this arrangement is known in professional circles as a gamma camera.

The task of the invention is to create a modular gamma camera for the detection of transient ionizing radiation, which would allow the creation of modular gamma camera assemblies to extend possible variants of scanning geometry in scanning transient ionizing radiation emanating from the object to be examined.

### Summary of the Invention

The set task is solved by creating a modular gamma camera according to the invention below.

The modular gamma camera comprises at least one semiconductor hybrid detector of transient ionizing radiation and at least one collimator of transient ionizing radiation arranged in front of the semiconductor hybrid detector in the direction of propagation of transient ionizing radiation.

The core of the invention is based on the fact that the modular gamma camera consists of a housing which contains at least one hybrid detector of transient radiation and which has at least one opening on the front side provided with a holder of an exchangeable collimator. The ability to exchange collimators preferably expands the range of scanning geometry variants in the examination of the measured object. At the same time, the housing of the modular gamma camera has a rear side provided with means for connecting a heat sink. When the heat sink is connected, it not only closes the rear side of the housing, but helps regulate the temperature inside the housing to prevent damage to the heat-sensitive components of the modular gamma camera. Furthermore, the housing has its sides provided with connecting means for modular chain connection of adjacent housings. This is convenient for creating modular gamma camera assemblies according to the immediate need for measurement to create a suitable scanning geometry of transient ionizing radiation.

In a preferred embodiment of the modular gamma camera according to the invention, the connecting means are realized as articulated couplings with holes for a removable pin. The removable pin prevents arbitrary disconnection of adjacent housings and the articulated coupling allows the chain to bend from the housings from a straight line into an arc.

Preferably, the modular gamma camera is equipped with a commercially available hybrid semiconductor detector called Timepix3 with a thickness of up to 2000 µm. This particular hybrid semiconductor detector is suitable for the detection and recording of a wide range of transient ionizing radiation.

In a preferred embodiment of the invention, an assembly of modular gamma cameras is formed, in which the housings in the assembly are connected in a circle. The circular arrangement allows to scan the measured object from multiple angles simultaneously. In terms of expanding the range of possible variants of the scanning geometry, it is a preferred variant if the assembly is formed by at least two circles arranged one above the other.

In another preferred embodiment of the invention, an assembly of modular gamma cameras is formed, in which the housings in the assembly are connected in a row. Such an arrangement makes it possible to increase the field of view in one direction for scanning larger objects from one side.

In a preferred embodiment of the assemblies according to the invention, the assemblies comprise at least one unmounted housing of a modular gamma camera. The use of unmounted housings again expands the range of possible variants of scanning geometry.

It is preferred if the assembly is provided with a shielding cylinder, or a shielding plate provided with passes for transmitting transient ionizing radiation to the opening of the housing. The shielding cylinder, or plate, protects the modular gamma camera from transient radiation coming from undesired directions. In addition, it helps fixing the modular gamma cameras of the assembly in precise positions of the scanning geometry.

The advantages of a modular gamma camera include the possibility to prepare various variants of scanning geometry, with a suitable assembly of modular gamma cameras, or with a suitable exchange of collimators. Modular gamma camera housings are robust enough to protect sensitive components of a modular gamma camera, but are also well chainable within an assembly.

### Explanation of drawings

The present invention will be explained in detail by means of the following figures where:
- Fig. 1: shows the gamma camera housing, including sections of the housing,
- Fig. 2: shows two modular gamma cameras, where one of the modular gamma cameras is shown with the front facing forward and the other of the modular gamma cameras is shown with the back facing forward,
- Fig. 3: shows a section of parts of a circular assembly of modular gamma cameras and the principle of the imaging method,
- Fig. 4: shows an assembly of modular gamma cameras in a circular arrangement,
- Fig. 5: shows an assembly of modular gamma cameras in a circular two-level arrangement,
- Fig. 6: shows an assembly of modular gamma cameras in a row arrangement.

### Example of the Invention Embodiments

It shall be understood that the specific cases of the invention embodiments described and depicted below are provided for illustration only and do not limit the invention to the examples provided here. Those skilled in the art will find or, based on routine experiment, will be able to provide a greater or lesser number of equivalents to the specific embodiments of the invention which are described here.

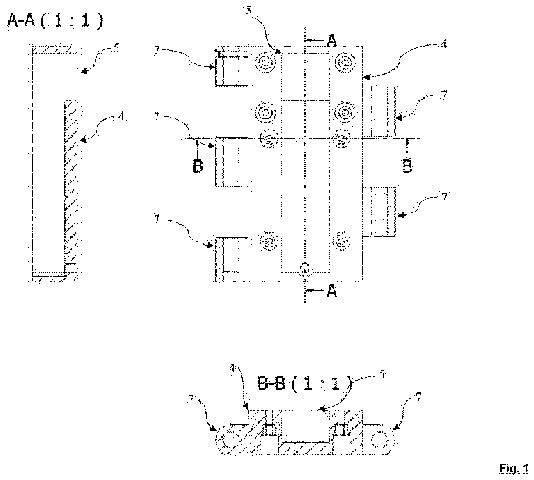

Fig. 1 shows a housing **4** of a modular gamma camera **1.** The housing **4** is hollow to accommodate the hybrid semiconductor detector **2,** as better illustrated with sections A-A and B-B. The front side of the housing **4** is provided with an opening **5** for undistorted passage of transient ionizing radiation. The rear side of the housing **4** is partially open for the installation of components and is provided with means for fixing the heat sink **6,** e.g. threads for screws. The heat sink **6** is located on the back of the housing **4** and can be provided with an additional passive finned heat sink. Articulated couplings **7** are formed on the sides of the housing **4,** which, when seated with the adjacent housing **4,** are connected by a removable pin **8** passing through the articulated couplings **7.** The housing **4** is made of metal or hard plastic, while the heat sink **6** is made of metal with a high thermal conductivity value.

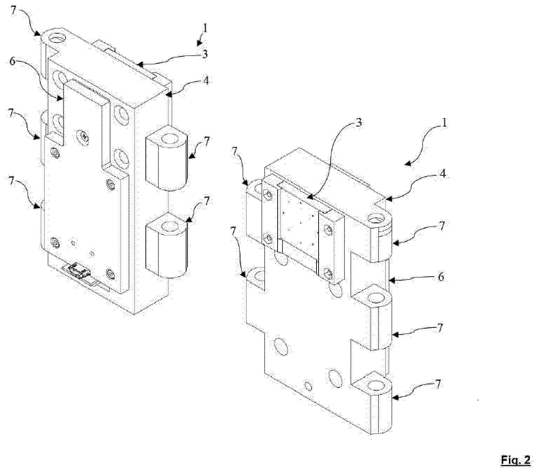

Fig. 2 shows two modular gamma cameras **1.** On the front side of the housing **4,** an exchangeable collimator **3** is mounted in a screwed-on holder. A heat sink **6** is mounted on the back of the housing **4.** The person skilled in the art is able to routinely describe and design various types of exchangeable collimators **3** for adjusting the scanning geometry.

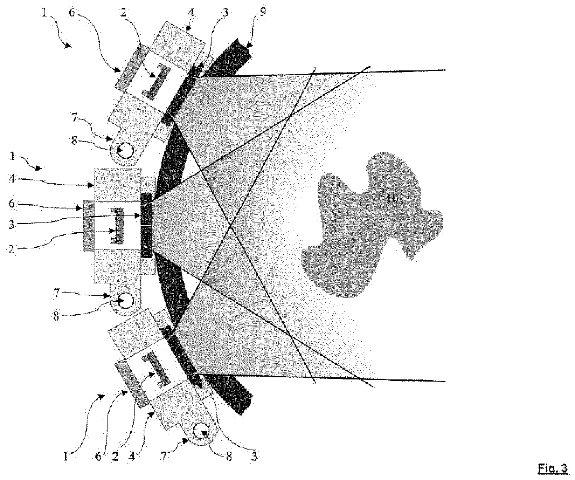

Fig. 3 shows a section through a section of a circular assembly of modular gamma cameras **1** and the principle of scanning the measured sample **10.** The modular gamma cameras **1** are chain-connected by means of articulated couplings **7** secured by removable pins **8.** The housings **4** contain hybrid semiconductor detectors **2,** e.g. Timepix3 with a thickness up to 2000 µm, but the person skilled in the art can suggest the use of other known hybrid semiconductor detectors **2.** The individual modular gamma cameras **1** are shielded by a shielding cylinder **9** with passes of transient ionizing radiation. In addition, the modular gamma cameras **1** adjacent to the shielding cylinder **9** ensure that in the event of an external force acting on any of the modular gamma cameras **1** of the assembly, the shielding cylinder **9** prevents it from deviating from a given position in the assembly. The shielding cylinder **9** is made of a material with a high value of absorption of transient ionizing radiation, e.g. lead, tungsten, etc.

The hybrid semiconductor detectors **2** are connected to USB2 connectors (not shown) for easy connection to a data acquisition computer.

In another embodiment of the modular gamma cameras **1,** their housings **4** may be made of a material that can shield transient ionizing radiation.

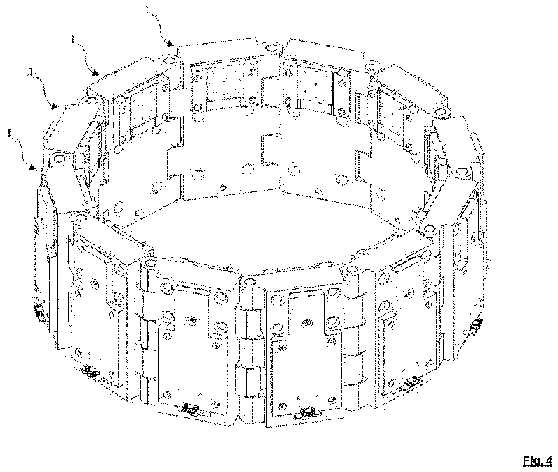

Fig. 4 shows a circular assembly of twelve modular gamma cameras **1.**

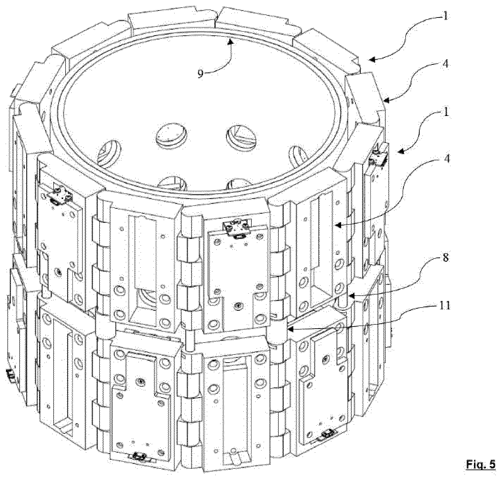

Fig. 5 shows a two-level circular assembly of twelve modular gamma cameras **1** and of twelve unmounted housings **4.** The alternation of the modular gamma camera **1** and the unmounted housing **4** on the circular level allows another variant of the scanning geometry. The distance between the levels is solved by using equally high distance spacers **11** mounted on removable pins **8.**

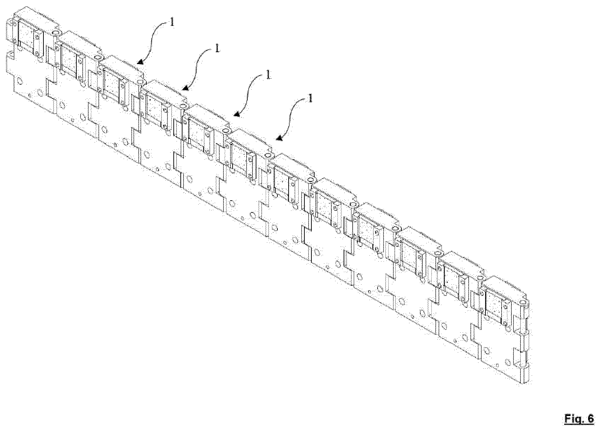

Fig. 6 shows a row assembly of twelve modular gamma cameras **1.**

### Industrial applicability

The modular gamma camera according to the invention will find its application in scientific applications, industry, medicine, and anywhere where it is necessary to scan transient ionizing radiation from multiple angles simultaneously in the context of imaging optically invisible structures and material analysis.

### List of reference numerals

- 1: modular gamma camera
- 2: hybrid semiconductor detector
- 3: collimator
- 4: housing
- 5: opening
- 6: heat sink
- 7: articulated coupling
- 8: removable pin
- 9: shielding cylinder
- 10: measured object
- 11: distance spacer

## Claims

1. Modular gamma camera (1) comprising at least one hybrid semiconductor detector (2) of transient ionizing radiation and at least one collimator (3) of transient ionizing radiation arranged in front of the hybrid semiconductor detector (2) in the direction of propagation of transient ionizing radiation **characterized in that** it consists of a housing (4) having at least one opening (5) on the front side provided with a holder of an exchangeable collimator (3), having a rear side provided with at least one means for connecting the heat sink (6), and which has its sides provided with connecting means for modular chain connection of adjacent housings (4), with at least one hybrid semiconductor detector (2) of transient radiation being placed in the housing (4).

2. Modular gamma camera according to claim 1, **characterized in that** the connecting means are realized as articulated couplings (7) with holes for an exchangeable pin (8).

3. Modular gamma camera according to claim 1 or 2, **characterized in that** the hybrid semiconductor detector (2) is a Timepix3 with a thickness of up to 2000 µm.

4. Modular gamma camera assembly (1) according to any of claims 1 to 3, **characterized in that** the housings (4) in the assembly are connected in a circle.

5. Assembly according to claim 4, **characterized in that** it is formed by at least two circles arranged one above the other.

6. Modular gamma camera assembly (1) according to any of claims 1 to 3, **characterized in that** the housings (4) in the assembly are connected in a row.

7. Assembly according to any of claims 4 to 6, **characterized in that** it comprises at least one unmounted housing (4) of a modular gamma camera (1).

8. Assembly according to any of claims 4 to 7, **characterized in that** it is provided with a shielding cylinder (9) or a shielding plate provided with passes for transmitting transient ionizing radiation to the opening (5) of the housing (4).
